(19) Europäisches Patentamt
European Patent Office
Office européen des brevets

(11) **EP 3 577 514 B1**

(12) # EUROPÄISCHE PATENTSCHRIFT

(45) Veröffentlichungstag und Bekanntmachung des Hinweises auf die Patenterteilung:
**24.01.2024  Patentblatt 2024/04**

(21) Anmeldenummer: **18705099.2**

(22) Anmeldetag: **29.01.2018**

(51) Internationale Patentklassifikation (IPC):
**G02B 27/09** (2006.01)    **G02B 19/00** (2006.01)
**G02B 27/30** (2006.01)    G02B 6/42 (2006.01)

(52) Gemeinsame Patentklassifikation (CPC):
**G02B 27/0916; G02B 19/0014; G02B 19/0052;
G02B 27/0922; G02B 27/30;** G02B 6/4296

(86) Internationale Anmeldenummer:
**PCT/EP2018/052061**

(87) Internationale Veröffentlichungsnummer:
**WO 2018/141670 (09.08.2018 Gazette 2018/32)**

(54) **VORRICHTUNG ZUR KOLLIMATION EINES LICHTSTRAHLS, HOCHLEISTUNGSLASER UND FOKUSSIEROPTIK SOWIE VERFAHREN ZUM KOLLIMIEREN EINES LICHTSTRAHLES**

DEVICE FOR THE COLLIMATION OF A LIGHT BEAM, HIGH POWER LASER AND FOCUSSING OPTICS AND METHOD FOR COLLIMATING A LIGHT BEAM

PROCÉDÉ POUR LA COLLIMATION D'UN RAYONNEMENT LUMINEUX, LASER HAUTE PUISSANCE ET OPTIQUE DE FOCALISATION ET PROCÉDÉ DE COLLIMATION D'UN RAYONNEMENT LUMINEUX

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **31.01.2017  EP 17153942**

(43) Veröffentlichungstag der Anmeldung:
**11.12.2019  Patentblatt 2019/50**

(73) Patentinhaber: **Fisba AG
9016 St. Gallen (CH)**

(72) Erfinder:
 • **MOSER, Hansruedi
  9452 Hinterforst (CH)**
 • **FORRER, Hans
  9016 St. Gallen (CH)**
 • **FORRER, Martin
  9050 Appenzell (CH)**
 • **HUBER, Michael
  9014 St. Gallen (CH)**

(74) Vertreter: **Hepp Wenger Ryffel AG
Friedtalweg 5
9500 Wil (CH)**

(56) Entgegenhaltungen:
**US-A- 5 790 576      US-A1- 2016 274 368
US-B1- 6 195 208**

 • **MITSUO NOHARA ET AL: "Aspheric Lens Laser Diode Collimator Design for Optical Intersatellite Communications", JAPANESE JOURNAL OF APPLIED PHYSICS, Bd. 33, Nr. Part 1, No. 3A, 15. März 1994 (1994-03-15), Seiten 1363-1364, XP055378913, JP ISSN: 0021-4922, DOI: 10.1143/JJAP.33.1363**
 • **Martin Hünten ET AL: "Precision glass molding: an integrative approach for the production of high precision micro-optics", Proceedings of SPIE, vol. 7591, 11 February 2010 (2010-02-11), page 75910X, XP055751633, 1000 20th St. Bellingham WA 98225-6705 USA ISSN: 0277-786X, DOI: 10.1117/12.840271 ISBN: 978-1-5106-3927-0**
 • **Anonymous: "Aspheric lens - Wikipedia", , 22 November 2012 (2012-11-22), XP055713560, Retrieved from the Internet: URL:https://en.wikipedia.org/w/index.php?title=Aspheric_lens&oldid=524390249 [retrieved on 2020-07-10]**

- **SERKAN M ET AL: "Optical beam-shaping design based on aspherical lenses for circularization, collimation, and expansion of elliptic al laser beams", APPLIED OPTICS, OPTICAL SOCIETY OF AMERICA, WASHINGTON, DC, US, vol. 47, no. 2, 10 January 2008 (2008-01-10), pages 230-241, XP001511074, ISSN: 0003-6935, DOI: 10.1364/AO.47.000230**

**Beschreibung**

Die vorliegende Erfindung betrifft eine Vorrichtung zur Kollimation eines Lichtstrahls, einen Hochleistungslaser und eine Fokussieroptik sowie ein Verfahren zum Kollimieren eines Lichtstrahles gemäss dem Oberbegriff der unabhängigen Ansprüche.

Vorrichtungen zum Kollimieren eines Lichtstrahles werden unter anderem in Hochleistungs-Diodenlasern und in Quantenkaskadenlasern eingesetzt. Typischerweise finden derartige Vorrichtungen Anwendung bei Lasern mit einem asymmetrischen Strahlfeld.

Ein Hochleistungs-Diodenlaser ist ein Halbleiterlaser mit einer Breitstreifenstruktur, um die Emission hoher Leistungen als Lichtstrahl im Wattbereich zu ermöglichen. Ein solcher Einzelemitter erzeugt einen Lichtstrahl aus einer Ursprungsebene mit einer relativ zu dieser vorgegeben Strahlrichtung. Entlang dieser Strahlrichtung erstrecken sich zwei Ebenen, eine erste Ebene (Fast-Axis) und eine dazu orthogonale Ebene (Slow-Axis). Der Strahl weist in der ersten Ebene eine andere Strahlcharakteristik auf als in der zweiten Ebene. Der Einzelemitter hat in der Ursprungsebene in der Fast Axis als Single Mode Emitter eine Dimension in der Grössenordnung von 1 micron und hat in dieser Ebene eine numerische Apertur von 0.5 - 0.7. In der Slow-Axis hat der Einzelemitter in der Ursprungsebene je nach Art bei Single Mode oder Multi Mode Emittern eine Dimension von 3 - 200 micron und der Lichtstrahl hat in dieser Ebene eine numerische Apertur von 0.05 - 0.2. Dies je nach Wellenlänge und Leistung der verwendeten Laserquelle.

Da diese Hochleistungs-Diodenlaser häufig in einen Lichtwellenleiter eingekoppelt werden, ist für eine Fokussierung ein möglichst symmetrisches Lichtstrahlungsfeld vor der Fokussieroptik anzustreben. Dabei ist es aus dem Stand der Technik bekannt, dies mit separater Kollimation in der Fast-Axis und Slow-Axis zu realisieren. Dabei wird zuerst die Fast-Axis mit einer zylindrischen Kollimationslinse FAC (Fast Axis Collimator) nur in dieser Ebene kollimiert. Danach werden in der Slow Axis Ebene mit einer zylindrischen Kollimationslinse SAC (Slow Axis Collimator) die Anteile der Lichtstrahlen in dieser Ebene kollimiert. Das Lichtstrahlungsfeld nach der FAC und SAC wird danach mit einer Fokussieroptik auf den Faserkern fokussiert.

Häufig werden zur Leistungssteigerung Laserdioden-Arrays mit mehreren Emittern auf einem Chip verwendet. Auch in diesem Fall wird eine FAC zur Kollimation eingesetzt. Da jedoch mehrere Emitter in der Ursprungsebene entlang der Slow Axis Ebene nebeneinander angeordnet sind, muss jeder Emitter mit einer separaten SAC kollimiert werden. Dies wird meist mit einem Array von nebeneinander liegenden SACs realisiert. Dabei muss der Abstand der SAC mit dem Abstand der Emitter übereinstimmen.

Weiter werden auch Chips mit mehreren Emittern in der Ursprungsebene, die entlang der Fast Axis Ebene nebeneinander angeordnet sind, verwendet. Auch in diesem Fall wird nur eine FAC zur Kollimation eingesetzt, da die Emitter in einem Abstand zwischen 5 und 20 micron liegen. Somit ist ein Laserdioden-Array in Slow und Fast Axis Ebene möglich.

Strahlung oder Anteile des Lichtes, die sich aber weder in der Fast Axis Ebene noch in der Slow Axis Ebene ausbreiten, werden nur ungenügend kollimiert. Es resultiert ein verwaschenes und zum Teil unscharfes Feld. Daraus kann sich, beispielsweise bei der Einkopplung in einen Glasfaserleiter, ein Leistungsverlust ergeben, da nicht die vollständige Strahlung eingekoppelt werden kann, sondern im Wesentlichen nur der Teil, der vollständig kollimiert ist.

Typischerweise ist die numerische Apertur bei kurzwelligen Lichtstrahlen, beispielsweise von einer blauen Laserdiode mit einer Wellenlänge von ungefähr 450nm, grösser. Dadurch ergeben sich ebenfalls grössere Verluste.

Aus der Druckschrift Jpn. J Appl. Phys. Vol. 33 (1994) pp 1363-1364 ist eine Kollimationsanordnung mit asphärischen Linsen bekannt, bei welcher zunächst mittels einer Linse zirkular kollimiert wird und im weiteren Strahlverlauf zwei Zylinderlinsen angeordnet sind. Alternativ können zwei anamorphe Linsen, die jeweils auf einer Seite konvex und auf der anderen Seite konkav sind, nacheinander angeordnet sein.

Die Druckschrift US 2016/0274368 A1 offenbart eine Diodenanordnung mit einem Feld von Dioden, die jeweils mit einem "Fast Axis"-Kollimator versehen sind. In Abstrahlrichtung schliesst sich ein Feld von sphärisch/asphärischen Teleskopeinheiten an und anschliessend ein Feld von Zylinderlinsen. Abschliessend umfasst die Anordnung eine Fokussiereinheit mit Kollimierlinsen.

Die Druckschrift US 6195208 B1 offenbart eine asphärische Linse, mit welcher eine astigmatischer, nicht zirkularer, divergierender Laserstrahl in einen kollimierten, zirkularen Laserstrahl konvertiert wird. Die Eingangsfläche hat ein konkaves asphärisches Profil in Transversalrichtung und eine konvexes asphärisches Profil in Longitudinalrichtung, die Ausgangsfläche konvexes asphärisches Profil in Transversalrichtung und ein nicht gekrümmtes Profil in Longitudinalrichtung.

Die Druckschrift Martin Hunten ET AL: "Precision glass molding: an integrative approach for the production of high precision micro-optics", Proceedings of SPIE, Bd. 7591, 11. Februar 2010 (2010-02-11), Seite 75910X, XP055751633, 1000 20th St. Bellingham WA 98225-6705 USA offenbart eine Anordnung mit einem dritten optischen Element, einer so genannte Phasenplatte, die als freigeformte Glasoptik ausgebildet ist. Mit diesem Element können Maxima höherer Ordnung eliminiert werden. Es sei denkbar, die drei Funktionen in ein optisches Element zu integrieren.

Die Druckschrift SERKAN M ET AL: "Optical beam-shaping design based on aspherical lenses for circularization, collimation, and expansion of elliptic al laser beams", APPLIED OPTICS, Bd. 47, Nr. 2, 10. Januar 2008 (2008-01-10), Seiten 230-241, offenbart eine einlinsige Ausführung für ein Lidarsystem, bei welchem die Frontseite anamorphotisch mit zwei unterschiedlichen Brechungsrichtungen ist und die Rückseite eine zylindrische Oberfläche aufweist.

Es ist Aufgabe der Erfindung diese und weitere Nachteile des Standes der Technik zu beheben.

Diese Aufgabe wird durch die in den unabhängigen Patentansprüchen definierten Vorrichtungen und Verfahren gelöst. Weitere Ausführungsformen ergeben sich aus den abhängigen Patentansprüchen.

Die Aufgabe wird gelöst durch eine erfindungsgemässe Vorrichtung zur Kollimation eines eingehenden Lichtstrahlungsfeldes mit einer Strahlcharakteristik bezüglich der Divergenz, also hinsichtlich des Abstrahlwinkels gegenüber der Stahlrichtung, die in einer ersten Ebene unterschiedlich zu einer zweiten Ebene ist. Das Lichtstrahlungsfeld umfasst mindestens einen von einer Lichtquelle emittierten Lichtstrahl, der in Strahlrichtung entlang einer Fast-Axis schnell divergiert und entlang einer dazu senkrechten Slow-Axis langsamer divergiert. Die erste Ebene wird bevorzugt durch die Fast-Axis-Richtung des Lichtemitters und die Strahlrichtung aufgespannt, die zweite Ebene durch die Slow Axis Richtung des Lichtemitters und die Strahlrichtung, sodass die Ebenen orthogonal zueinander stehen. Es unterscheidet sich also der Abstrahlwinkel in der ersten Ebene entlang der Strahlrichtung von dem Abstrahlwinkel in der zweiten Ebene entlang der Strahlrichtung.

Die Vorrichtung dient zur Kollimation eingehender Lichtstrahlen, die einen nichtkreisförmigen Querschnitt senkrecht zur Strahlrichtung aufweisen und sich insbesondere durch eine sphärische Fokussierlinse nicht fokussieren lassen, wie dies üblicherweise bei durch Laserdioden erzeugten Lichtstrahlen der Fall ist.

Die Vorrichtung umfasst wenigstens eine erste Kollimationslinse zur Kollimation des Lichtstrahlungsfeldes in der ersten Ebene und mindestens eine zweite Kollimationslinse zur Kollimation des Lichtstrahlfeldes in der zweiten Ebene.

Die Kollimationslinsen für die orthogonalen Ebenen sind in Abstrahlrichtung hintereinander angeordnet. Erfindungsgemäß sind die erste und zweite Kollimationslinse so angeordnet, dass zunächst die Kollimation in der Fast-Axis-Ebene und anschliessend eine Kollimation in der Slow-Axis-Ebene erfolgt. Die Fast-Axis Kollimation erfolgt beispielsweise mit einer Zylinderlinse, die ein polynomiales Profil aufweist. Die Slow-Axis Kollimation erfolgt mit einer Zylinderlinse mit polynomialem Profil.

Die Kollimation bewirkt, dass die jeweiligen divergierenden Anteile des Lichtstrahlungsfeldes parallel zur Strahlrichtung ausgerichtet werden. Das Lichtstrahlungsfeld umfasst allerdings Anteile, die nach der ersten Kollimation, zum Beispiel der Fast-Axis-Kollimation, und der zweiten Kollimation, zum Beispiel der Slow-Axis Kollimation, noch nicht parallel ausgerichtet sind. Wird das Lichtstrahlungsfeld ohne Korrektur unmittelbar nach der ersten und zweiten Kollimation, zum Beispiel der Fast-Axis-Kollimation und der Slow-Axis Kollimation, mit einer Fokussieroptik fokussiert, so werden diese Anteile nicht oder nur unzureichend im Zielgebiet abgebildet und können zu einem Leistungsverlust führen.

Die Vorrichtung weist erfindungsgemäss ein zusätzliches optisches Element auf, welches derart konfiguriert ist, dass Anteile des Lichtstrahlungsfeldes, die durch die erste und zweite Kollimationslinse, also zum Beispiel nach der Fast-Axis-Kollimation und der Slow-Axis Kollimation, noch nicht parallel ausgerichtet sind, parallel zur Strahlrichtung ausgerichtet werden.

Erfindungsgemäß werden im Wesentlichen alle Anteile, die noch nicht parallel ausgerichtet sind durch das optische Element parallel ausgerichtet. Der Lichtstrahl wird zumindest in einer zur ersten und zur zweiten Ebene unterschiedlichen Ebene, die ebenfalls entlang der Strahlrichtung verläuft und insbesondere in allen zur ersten und zur zweiten Ebene unterschiedlichen Ebenen kollimiert. Insbesondere wird der Lichtstrahl durch das weitere optische Element nicht in der ersten und nicht in der zweiten Ebene kollimiert.

Wie vorliegend dargelegt, weist der eingehende Lichtstrahl naturgemäß eine Fast-Axis-Ebene und eine Slow-Axis-Ebene auf. Zwischen diesen Ebenen weist der Lichtstrahl Anteile an "schiefen" Ausbreitungsrichtungen auf, welche sich nicht nur in diesen Ebenen ausbreiten und welche sich nicht durch eine Fast-Axis-Kollimation und der Slow-Axis Kollimation kollimieren, das heisst, parallel zur Strahlrichtung ausrichten, lassen. Mit dem zusätzlichen optischen Element können diese Anteile des Lichtstrahls ebenfalls kollimiert werden.

Das zusätzliche Element lässt die bereits in der Fast-Axis-Kollimation und der Slow-Axis Kollimation ausgerichteten Anteile des Lichtstrahls unbeeinflusst.

Die Vorrichtung ist so konfiguriert, dass das ausgehende Lichtstrahlungsfeld im Wesentlichen nur parallel zur Strahlrichtung ausgerichtete Anteile aufweist.

Dies ermöglicht eine vollständige Kollimation des Lichtstrahlungsfeldes und dadurch eine Leistungssteigerung, da ein im Vergleich zum Stand der Technik grösserer Anteil des Lichtstrahlungsfeldes kollimiert ist und daher gebündelt werden kann. Das heisst, dass ein grösserer Anteil des Lichtstrahlungsfeldes mit einer Fokussieroptik in einen bestimmten Bereich fokussiert werden kann.

In einer alternativen Ausgestaltung, welche nicht unter den Schutzumfang der beigefügten Ansprüche fällt, kann das zusätzliche optische Element, wie aus dem Stand der Technik bekannt ist, unabhängig von der ersten und zweiten Kollimationslinse durch eine separate Kollimationslinse gebildet sein.

Erfindungsgemäss werden die erste und die zweite Kollimationslinse einteilig ausgebildet, so dass die erste und die zweite Linse auch durch das gleiche physische Element gebildet werden.

In einer alternativen Ausgestaltung, welche nicht unter den Schutzumfang der beigefügten Ansprüche fällt, kann das zusätzliche optische Element, wie aus dem Stand der technik bekannt ist, durch eine dritte Kollimationslinse gebildet sein.

Eine dritte Kollimationslinse ermöglicht es, diese mit einer Krümmung zu fertigen, die spezifisch auf die Anteile der "schiefen" Ausbreitungsrichtungen ausgelegt ist.

Dabei ist es möglich, die dritte Kollimationslinse in Strahlrichtung des Lichtstrahls nach der ersten und nach der zweiten Kollimationslinse anzuordnen.

Dies ermöglicht es, die Kollimation in drei Schritten durchzuführen, wobei in einem ersten Schritt die Kollimation in der Fast Axis durchgeführt wird, in einem zweiten Schritt die Kollimation in der Slow Axis und in einem dritten Schritt die Kollimation der "schiefen" Ausbreitungsrichtungen, das heisst der Anteile des Lichtes, welches auf keiner dieser beiden Ebenen liegt.

Die Anordnung des zusätzlichen optischen Elementes, am Schluss der Kollimationskette weist den Vorteil auf, dass ein grosser Teil des Lichtstrahlungsfeldes bereits in Fast Axis Ebene und Slow Axis Ebene kollimiert ist und mit dem zusätzlichen Element nur noch die Anteile der nicht in diesen Ebenen liegenden "schiefen" Ausbreitungsrichtungen fertig kollimiert werden müssen. Typischerweise wird der Anteil der "schiefen" Ausbreitungsrichtungen in diesen Ebenen bereits durch die erste und die zweite Kollimationslinse vorkollimiert. Dabei findet jedoch keine vollständige Kollimation statt. Mit dem zusätzlichen optischen Element werden nun diese Anteile des Lichtstrahlungsfeldes fertig kollimiert, so dass danach im Wesentlichen das gesamte Lichtstrahlungsfeld kollimiert ist.

Je nach den entsprechenden Anforderungen kann es in einer alternativen Ausgestaltung, welche nicht unter den Schutzumfang der beigefügten Ansprüche fällt, vorteilhaft sein, die Anteile des Lichtstrahlungsfeldes, welche nicht durch die Fast-Axis-Kollimation und durch die Slow- Axis-Kollimation kollimierbar sind, welche also nicht auf den Hauptachsen liegen, zu kollimieren, bevor der Hauptanteil des Lichtes beispielsweise in der Slow-Axis kollimiert wird. Dies ermöglicht es, bereits vor einer abschliessenden Kollimation, die "schiefen" Ausbreitungsrichtungen des Lichtes ganz oder teilweise vorzukollimieren.

Erfindungsgemäss ist das zusätzliche optische Element jedoch durch einen Bereich auf der zweiten Kollimationslinse und als integraler Bestandteil der zweiten Kollimationslinse ausgebildet.

Dies ermöglicht es, auf ein drittes, separates Element zu verzichten. Die Baugrösse der Vorrichtung kann damit klein gehalten werden. Im Vergleich zu einer Vorrichtung mit einer dritten Kollimationslinse resultiert dies in einer Vorrichtung mit einer höheren Präzision. Eine Qualitätssteigerung ist somit möglich.

Die Vorrichtung besteht folglich aus einer ersten und einer zweiten Kollimationslinse, wobei die zweite Kollimationslinse das optische Element umfasst.

Kollimationslinsen weisen typischerweise in Strahlungsrichtung gesehen eine Eintrittsseite und eine Austrittsseite auf.

In einer alternativen Ausgestaltung, welche nicht unter den Schutzumfang der beigefügten Ansprüche fällt, kann es vorgesehen sein, den Bereich für das zusätzliche optische Element auf der Eintrittsseite der zweiten Kollimationslinse anzuordnen und die Fläche zur Kollimation des Lichtstrahlungsfeldes in der zweiten Ebene auf der zweiten Kollimationslinse in Strahlungsrichtung austrittsseitig anzuordnen.

Dies ermöglicht es, ähnlich wie bei einer dritten Kollimationslinse, die zweite Fläche zur Kollimation des Lichtstrahlungsfeldes und das optische Element unabhängig von den anderen optischen Elementen, wie den anderen Kollimationslinsen, zu fertigen und entsprechend den Bedürfnissen auszugestalten.

Erfindungsgemäss wird jedoch die Fläche zur Kollimation des Lichtstrahlungsfeldes in der zweiten Ebene mit dem zusätzlichen optischen Element kombiniert und auf der zweiten Kollimationslinse in Strahlungsrichtung austrittsseitig angeordnet.

Die entsprechende Oberfläche der Linse ist dann als Freiformfläche ausgebildet. Das heisst, diese Fläche kann entsprechend der Charakteristik des eintretenden Lichtstrahls in unterschiedlichen Richtungen unterschiedlich gekrümmt sein, derart, dass zusätzlich zur Kollimation des Hauptanteiles des Lichtes in der Slow Axis ebenfalls der Anteil des Lichtstrahls, welches weder durch eine Slow Axis Kollimation noch durch eine Fast Axis Kollimation parallel ausgerichtet wird, kollimiert wird.

Erfindungsgemäß ist das zusätzliche optische Element als Teil einer Freiformfläche ausgebildet, wobei deren Oberfläche zumindest zwei unterschiedliche Krümmungen in zwei unterschiedlichen Richtungen senkrecht zur Strahlrichtung aufweist und wobei zumindest eine der Krümmungen entlang einer Richtung senkrecht zur Strahlrichtung keinen konstanten Krümmungsradius aufweist.

Beispielsweise kann die Oberfläche in Richtung der Slow-Axis konvex gekrümmt sein und in der dazu senkrechten Richtung ebenfalls, insbesondere konkav, gekrümmt sein.

Dies ermöglicht es, Lichtstrahlen mit unterschiedlichen Eintrittsrichtungen gleichermassen zu kollimieren und zu bündeln.

Erfindungsgemäß ist die Freiformfläche entlang der Fast-Axis Richtung und/oder der Slow-Axis Richtung asphärisch gekrümmt.

Erfindungsgemäss weist eine Kollimierlinse, die das zusätzliche optische Element umfasst, eine Oberflächentopographie in der Form eines zweidimensionalen Polynoms gerader Ordnung auf.

Das Polynom weist bevorzugt Koeffizienten mit einem Wert kleiner null für die $x^{2n}$-Terme auf, insbesondere sind mindestens die Koeffizienten des $x^2$- und des $x^4$- Terms kleiner null. Die Koeffizienten der $y^{2n}$ Terme sind gleich null. Das Polynom weist bevorzugt Koeffizienten mit einem Wert grösser null für die $x^{2n}y^{2m}$ Terme auf, insbesondere ist mindestens der Koeffizient des $x^2y^2$- Terms grösser null.

Das Polynom hat erfindungsgemäss die Form

$$H(x,y) = a_{20} x^2 + a_{40} x^4 + a_{22} x^2 y^2 + a_{60} x^6 + a_{42} x^4 y^2 + a_{24} x^2 y^4$$

wobei H die Höhe der Oberfläche in Strahlrichtung angibt und wobei x und y die orthogonalen Koordinatenachsen in der Ebene senkrecht zur Strahlrichtung sind, wobei insbesondere die x-Achse in Richtung der Slow-Axis Richtung und die y-Achse in Richtung der Fast-Axis Richtung verläuft, und a spezifische Koeffizienten sind, die alle nicht null sind, in Abhängigkeit des Emitters.

Die Koeffizienten $a_{20}$, $a_{40}$ und $a_{60}$ sind bevorzugt kleiner null, insbesondere sind $a_{20}$ und $a_{40}$ kleiner null. Diese Anteile des Polynoms beschreiben für sich genommen eine Zylinderlinse und bewirken bevorzugt die Slow-Axis-Kollimation.

Die Koeffizienten der Mischterme $a_{22}$ und $a_{42}$ sind bevorzugt grösser null, insbesondere ist $a_{22}$ grösser null.

Erfindungsgemäss sind die erste Kollimationslinse und die zweite Kollimationslinse und das zusätzliche optische Element einstückig ausgebildet. Dabei ist es vorteilhaft, wenn dieses einstückige Element eine optische Eintrittsfläche und eine optische Austrittsfläche aufweist, wobei diese gemäss Anspruch 1 ausgebildet sind.

Erfindungemäss werden das Lichtstrahlungsfeld in der Slow Axis Ebene und die schiefen Anteile des Lichtstrahlungsfeldes gemeinsam ganz oder teilweise kollimiert.

Dies ermöglicht es, drei Kollimationen in Fast Axis Ebene, Slow Axis Ebene und allen Ebenen dazwischen in einem Element mit zwei optischen Flächen (Eintritts- und Austrittsfläche) zu vereinen. Dadurch kann die Präzision erhöht werden, bei gleichzeitig einfacherer Fertigung mit weniger Einzelteilen.

Ein weiterer Aspekt der Erfindung betrifft einen Hochleistungs-diodenlaser mit zumindest einem Emitter, bevorzugt mehreren Emittern und mindestens einer Vorrichtung wie vorliegend beschrieben. Insbesondere umfasst der Hochleistungsdiodenlaser einen Laserdiodenbarren, bei dem eine Vielzahl von Laserdioden nebeneinander angeordnet ist.

Zusammen mit der Vorrichtung zur Kollimation wie oben beschrieben kann ein entsprechender Hochleistungs-diodenlaser mit einer ausgewählten Charakteristik bereitgestellt werden, welcher eine im Vergleich zum Stand der Technik höhere Effizienz durch eine verbesserte Kollimation der gesamten emittierten Strahlung aufweist.

Der vorgeschlagene Hochleistungsdiodenlaser kann ein Array aus mehreren Emittern, die in einer Ursprungsebene entlang der Fast Axis oder entlang der Slow Axis Ebene nebeneinander angeordnet sind, umfassen. Das Array erzeugt ein Lichtstrahlungsfeld, das sich aus den Lichtstrahlen der jeweiligen Emitter zusammensetzt.

Dabei ist erfindungsgemäß jedem Emitter ein Slow-Axis- und ein Fast-Axis-Kollimator sowie ein zusätzliches optisches Element zugeordnet.

Ein Aspekt der Erfindung betrifft daher ein Array aus mehreren Kollimationslinsen, insbesondere für einen Hochleistungsdiodenlaser oder ein Modul wie vorliegend beschrieben.

Dieses Kollimationslinsenarray umfasst zwei oder mehrere erste Kollimationslinsen zur Kollimation des Lichtstrahlungsfeldes in einer ersten Ebene und zwei oder mehrere zweite Kollimationslinsen zur Kollimation des Lichtstrahls in einer zweiten Ebene, wobei die Ebenen senkrecht zueinander stehen und sich der Strahlrichtung schneiden.

Die ersten und zweiten Kollimationslinsen sind bezüglich der Strahlrichtung hintereinander angeordnet. Das Kollimationslinsenarray weist je erster und zweiter Kollimationslinse ein zusätzliches optisches Element auf, um die "schiefen" Ausbreitungsrichtungen des Lichtstrahlungsfeldes auch noch parallel zur Strahlrichtung auszurichten, also in einer zur ersten Ebene und zur zweiten Ebene unterschiedlichen Ebene zu kollimieren. Dabei ist das optische Element jeweils als Freiformfläche an der Austrittsseite der entsprechenden zweiten Kollimationslinse gefertigt.

Die Kollimation in der ersten Ebene kann in einer alternativen Ausgestaltung, welche nicht unter den Schutzumfang der beigefügten Ansprüche fällt, mit einer gemeinsamen Kollimationslinse für alle Emitter realisiert werden, da die Emitter in Slow Axis sehr genau nebeneinander liegen.

Zur Fast-Axis Kollimation eines Laserdiodenbarrens kann beispielsweise eine Zylinderlinse verwendet werden, die sich über die gesamte Länge des Laserdiodenbarrens erstreckt und die Zylinderachse parallel zur Längsrichtung des Barrens verläuft. Zur Slow-Axis Kollimation kann eine Linsenarray mit nebeneinander angeordneten Zylinderlinsen verwendet werden, wobei die Zylinderachsen senkrecht zur Strahlrichtung und senkrecht zur Längsrichtung des Barrens ausgerichtet sind.

Dies ermöglicht das Bereitstellen eines Hochleistungsdiodenlasers mit einer hohen Leistung, wobei jeder einzelne Emitter individuell kollimierbar ist, was eine maximale Effizienz ermöglicht. Diese Anordnung ermöglicht eine höhere Leistungsdichte bei einer Fokussierung innerhalb eines vorgegebenen Bereichs, da die "schiefen" Ausbreitungsrichtungen des Lichtstrahlungsfeldes für jeden Emitter vollständig kollimiert werden.

Ein weiterer Aspekt der Erfindung betrifft ein Modul umfassend eine Vorrichtung zur Kollimation gemäß Anspruch 1, und eine Fokussieroptik oder ein Modul umfassend einen Hochleistungsdiodenlaser gemäß Anspruch 3, und eine Fokussieroptik.

Dadurch ist es möglich, einen Lichtstrahl oder ein Lichtstrahlungsfeld mit der vorliegend beschriebenen Charakteristik, insbesondere mit parallel zur Strahlrichtung ausgerichteten Lichtstrahlungsfeldanteilen, und den vorliegend beschriebenen Vorteilen bereitzustellen, so dass eine Einkoppelung in ein entsprechendes Element mit hoher Effizienz möglich ist.

Ein weiterer Aspekt der Erfindung betrifft ebenfalls ein Verfahren zum Kollimieren eines Lichtstrahles mit einer Strahlcharakteristik, die hinsichtlich des Abstrahlwinkels in einer ersten Ebene unterschiedlich zu einer zweiten Ebene ist. Das Verfahren wird mit einer Vorrichtung gemäß Anspruch 1 durchgeführt.

Das Verfahren umfasst die Schritte

- erste Kollimation von Anteilen des Lichtstrahles einer ersten Ebene, insbesondere Fast-Axis-Kollimation,
- zweite Kollimation von Anteilen des Lichtstrahles einer zweiten Ebene, insbesondere Slow-Axis-Kollimation,
- dritte Kollimation von Anteilen des Lichtstrahlungsfeldes, welche durch die erste und zweite Kollimation noch nicht parallel zur Strahlrichtung ausgerichtet wurden, insbesondere die eine zur ersten Ebene und zur zweiten Ebene eine unterschiedliche Richtung aufweisen.

Dieses Verfahren ermöglicht es, einen höheren Anteil des Lichtstrahlungsfeldes zu kolliminieren und für eine spätere Fokussieroptik zur Verfügung zu stellen. Die Leistungsdichte wird dadurch erhöht.

Erfindungsgemäss werden dabei zwei Kollimationen kombiniert, das heisst mit einem optischen Element, durchgeführt, nämlich die zweite und dritte Kollimation, also die Kollimation von Anteilen des Lichtstrahlungsfeldes einer zweiten Ebene und die Kollimation von den Anteilen des Lichtstrahlungsfeldes, welche sowohl zur ersten Ebene als auch zur zweiten Ebene eine unterschiedliche Ebene aufweisen.

Anhand der folgenden Figuren wird die Erfindung erklärt. Es zeigen:

Figur 1: Eine Vorrichtung gemäss dem Stand der Technik

Figur 1a: Ein Detail der Vorrichtung gemäss der Figur 1

Figur 2: Das Lichtstrahlungsfeld nach der Kollimation in der ersten und zweiten Ebene der Vorrichtung gemäss der Figur 1

Figur 3: Eine nicht unter den Anspruch fallende Vorrichtung, bei welcher das zusätzliche optische Element als Bereich auf der Austrittsseite einer zweiten, separaten, Kollimationslinse ausgebildet ist

Figur 3a: Ein Detail der Vorrichtung aus Figur 3

Figur 4: Das Lichtstrahlungsfeld nach der Kollimation der Vorrichtung aus der Figur 3

Figuren 5a bis 6c: Vergleichsversuche zu den Vorrichtungen aus den Figuren 1 und 3.

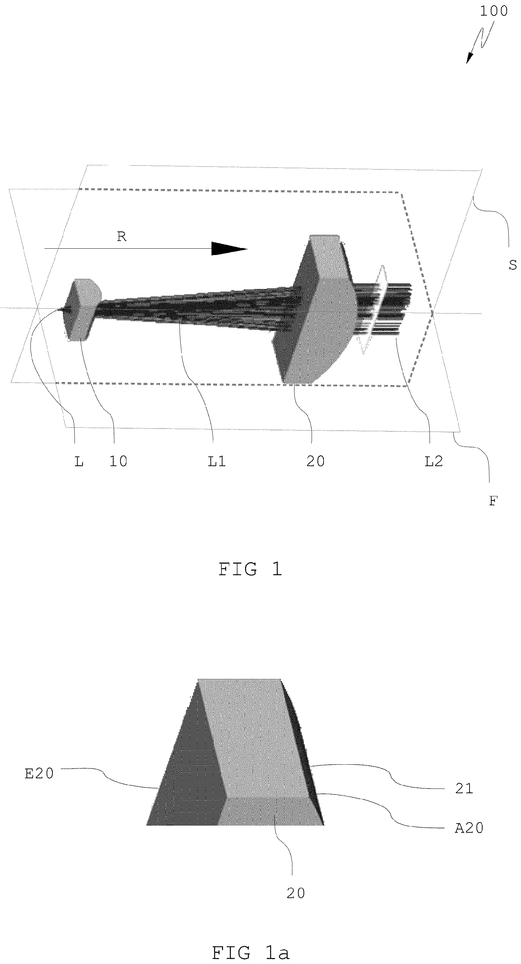

Die Figur 1 zeigt eine Vorrichtung zum Kollimieren eines Lichtstrahls gemäss dem Stand der Technik. Das Lichtstrahlungsfeld L einer Lichtquelle (eines Emitters) weist eine Strahlrichtung R auf und tritt nacheinander durch eine erste Kollimationslinse 10 und eine zweite Kollimationslinse 20.

Die Lichtquelle (Emitter) ist in vorliegender Figur nicht gezeigt. Der Emitter definiert eine Ursprungsebene, aus welcher sich das Lichtstrahlungsfeld L mit einer Strahlrichtung R erstreckt. Entlang dieser Strahlrichtung R erstrecken sich zwei Ebenen, eine erste Ebene F (Fast-Axis) und eine dazu orthogonalen Ebene S (Slow-Axis), die sich in Strahlrichtung schneiden. Das Lichtstrahlungsfeld L weist in der ersten Ebene F eine andere Strahlcharakteristik hinsichtlich der Divergenz auf als in der zweiten Ebene S.

Dabei wird der Anteil des Lichtstrahlungsfeldes in der ersten Kollimationslinse 10 in der Fast-Axis Ebene F kollimiert. Das Lichtstrahlungsfeld L weist danach eine neue Charakteristik auf und ist als Lichtstrahlungsfeld L1 bezeichnet. Das Lichtstrahlungsfeld L1 tritt in die zweite Kollimationslinse 20 ein, welche das Licht in der Slow-Axis Ebene S kollimiert. Das gerichtete (kollimierte) Lichtstrahlungsfeld L1 weist nach der zweiten Kollimationslinse 20 wiederum eine neue Charakteristik auf und ist als Lichtstrahlungsfeld L2 bezeichnet.

Die Figur 1a zeigt ein Detail der Kollimationslinse 20 aus der Figur 1 mit einer Eintrittsseite E20 und einer Austrittsseite A20. An der Austrittsseite A20 ist eine Fläche 21 zur Kollimation des Lichtstrahlungsfeldes in der zweiten Ebene angeordnet. Die Fläche 21 ist vorliegend zylindrisch ausgebildet.

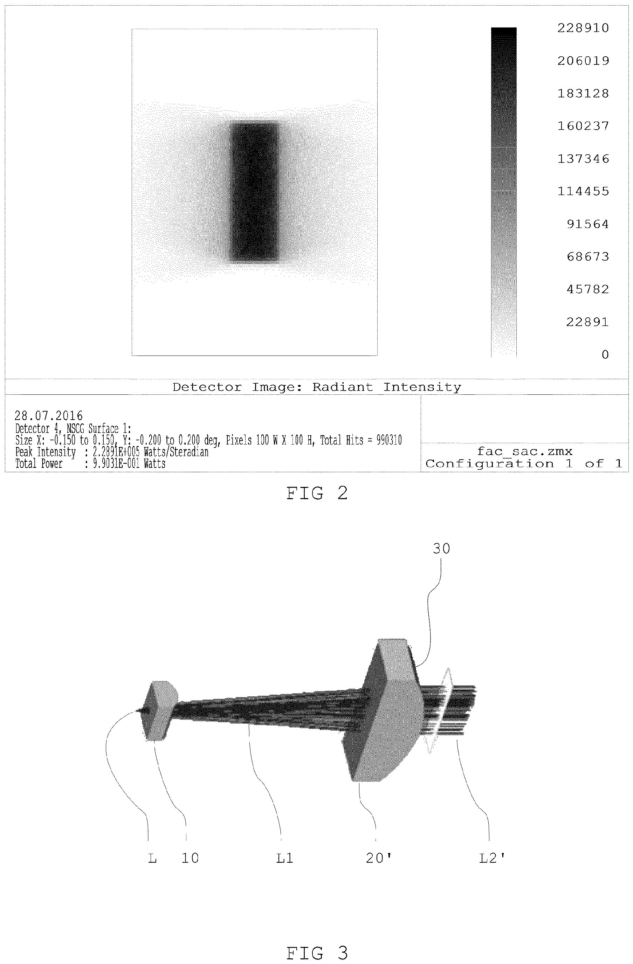

Die Figur 2 zeigt eine Simulation des Feldes nach einer FAC und SAC Kollimation mit einer Vorrichtung aus dem Stand der Technik gemäss Figur 1. Erkennbar sind die verwaschenen Bereiche am Rand des Feldes, welche aus den nicht kollimierten Anteilen des Lichtstrahlungsfeldes resultieren, welche auf keiner der beiden Ebenen liegen.

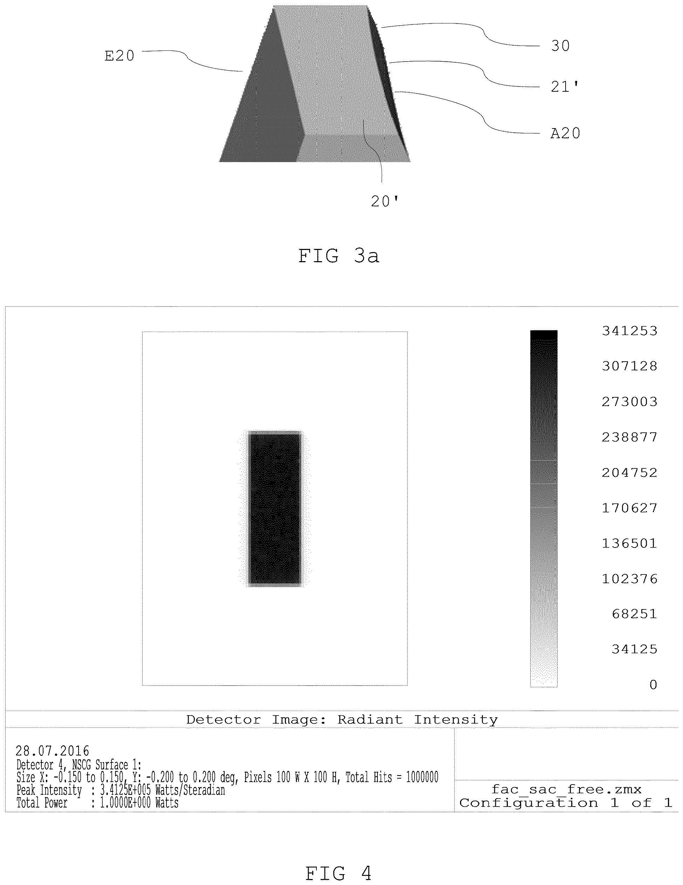

Figur 3 zeigt eine Vorrichtung, bei welcher das zusätzliche optische Element als Bereich auf der Austrittsseite der zweiten Kollimationslinse 20' ausgebildet ist. Die Vorrichtung aus Figur 3 entspricht in ihrem Aufbau der Vorrichtung aus Figur 1 mit einer ersten Kollimationslinse 10 und einer Kollimationslinse 20'. Die zweite Kollimationslinse 20' ist vorliegend mit einem zusätzlichen optischen Element 30 ausgebildet. Das Lichtstrahlungsfeld einer Lichtquelle L tritt ebenfalls wie in Figur 1 zuerst durch die erste Kollimationslinse 10 und breitet sich danach als Lichtstrahlungsfeld L1 weiter durch die zweite Kollimationslinse 20' aus und verlässt die zweite Kollimationslinse 20' als Lichtstrahlungsfeld L2'.

Figur 3a zeigt das zu Figur 1 entsprechende Detail aus Figur 3, nämlich einen Teil der Linse der zweiten Kollimationslinse 20'. Die Kollimationslinse 20' weist die Eintrittsseite E20 und die Austrittsseite A20 auf. Eine Fläche 21' zur Kollimation des Lichtstrahlungsfeldes in der zweiten Ebene ist integral mit dem zweiten zusätzlichen optischen Element 30 gefertigt. Die Fläche 21' ist ähnlich wie die Fläche 21 aus Figur 2a im Grundsatz zylindrisch mit einer polynomialen Krümmung ausgebildet. Jedoch ist diese zylindrische Ausbildung überlagert mit einer Freiformfläche, welche das zusätzliche optische Element 30 bildet. Vorliegend ist der Bereich der kombinierten Flächen 30, 21' zusätzlich zur Konvexität der grundsätzlich zylindrischen Ausbildung quer dazu leicht konkav ausgebildet.

Entsprechend der beanspruchten Erfindung ist die Freiformfläche nach der Formel

$$h(x,y) = a_{20}\,x^2 + a_{40}\,x^4 + a_{22}\,x^2y^2 + a_{60}\,x^6 + a_{42}\,x^4y^2 + a_{24}\,x^2y^4$$

gestaltet. Dies ermöglicht die Kollimation des Lichtstrahlungsfeldes in der Slow Axis Ebene und zusätzlich die Kollimation des Lichtes, welches sich weder in der Slow Axis Ebene noch in der Fast Axis Ebene ausbreitet.

Die Freiformfläche kann in einer alternativen Ausgestaltung, welche nicht unter den Schutzumfang der beigefügten Ansprüche fällt, nach dem Polynom

$$h(x,y) = a_{20} * x^2 + a_{22} * x^2 * y^2 + a_{40} * x^4$$

gestaltet sein, wobei $a_{20}$ und $a_{40}$ kleiner null sind und $a_{22}$ grösser null ist, zum Beispiel $a_{20} = -6.250e^{-02}$, $a_{22} = -2.14e^{-03}$ und $a_{04} = -1.07e^{-04}$. Der Wert der Koeffizienten wird typischerweise in Abhängigkeit von der Brechkraft der Kollimationslinse festgelegt, also zum Beispiel von der Art und Dicke des Glases.

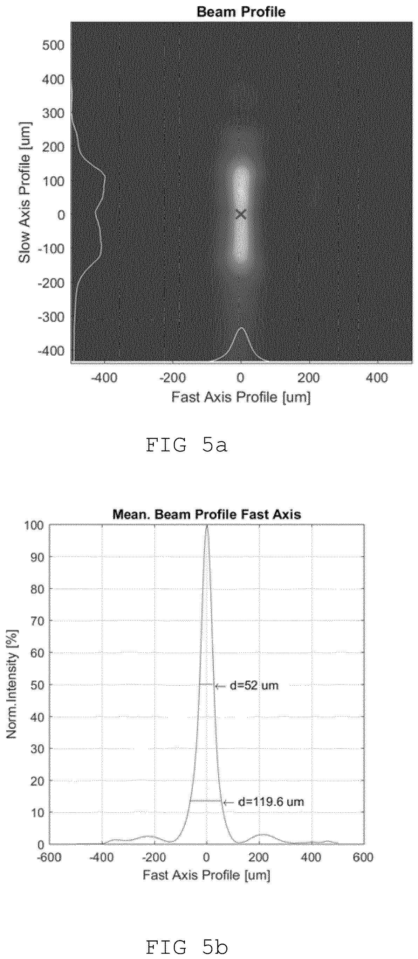

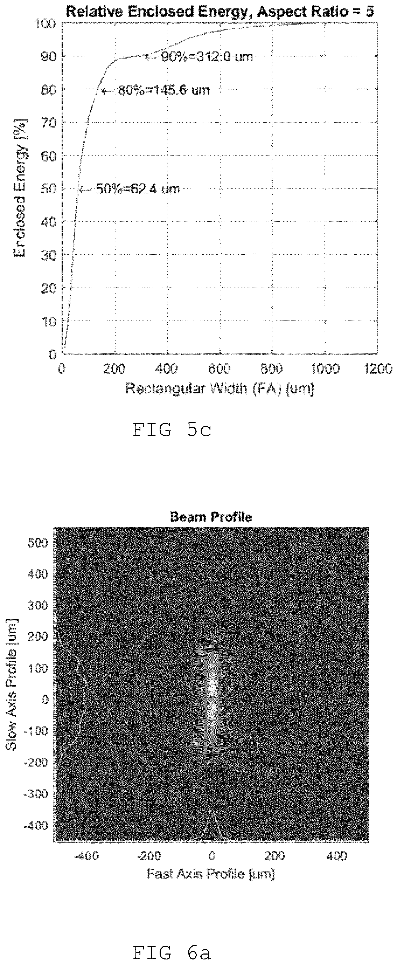

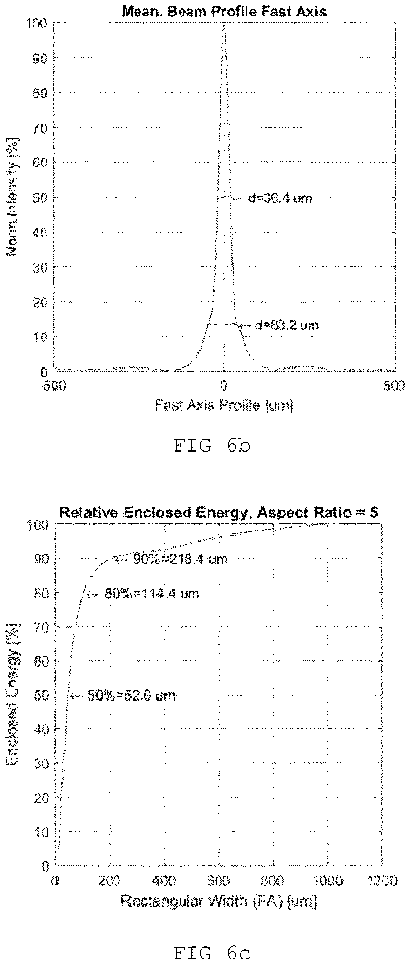

Die Figur 4 zeigt eine Simulation des Lichtstrahlungsfeldes nach FAC und SAC in Kombination mit der zusätzlichen Kollimation mit dem Element 30 in der dazu unterschiedlichen Ebene. Im Gegensatz zur Simulation aus der Figur 2 sind hier keine verschwommenen Randbereiche mehr ersichtlich. Die Energie in einem definierten Bereich ist erhöht. Dies zeigt sich auch in den Figuren 5a bis c (Stand der Technik gemäss Figur 1) im Vergleich zu den Figuren 6a bis c (Vorrichtung gemäss Figur 3, welche sich vom beanspruchten Gegenstand darin unterscheidet, dass die erste Kollimationslinse 10 und die zweite Kollimationslinse 20' nicht einstückig ausgebildet sind).

Die Figuren 5a und 6a zeigen jeweils das Profil des Lichtstrahlungsfeldes nach der Kollimation und der Fokussierung mit einer Fokussieroptik. Dabei ist in Figur 6a eine geringere Verbreiterung des Strahlprofils durch die nicht optimal kollimierten "schiefen" Ausbreitungsrichtungen erkennbar, wobei zentral zudem eine höhere Intensität feststellbar ist. Fig. 5b und 6b zeigen das normierte Strahlprofil in Fast Axis Ebene. Der Vergleich zeigt die Verbesserung im Strahlquerschnitt und die reduzierten Nebenmaxima. Fig. 5 c und 6 c zeigen die eingeschlossene Energie in einem definierten Bereich. Der Vergleich zeigt eine wesentlich verbesserte Effizienz der vorgeschlagenen Lösung. Beispielsweise werden mit der erfindungsgemässen Lösung mit dem verwendeten Aufbau von FAC und SAC oder SAC mit erfindungsgemässer Optimierung und Fokussieroptik 90 % der Energie in einen im Vergleich zum Stand der Technik um den Faktor 2 kleineren Bereich fokussiert.

## Patentansprüche

**1.** Vorrichtung (100) zur Kollimation eines von mindestens einem Lichtemitter ausgehenden Lichtstrahlungsfeldes (L) mit einer Strahlcharakteristik hinsichtlich des Abstrahlwinkels gegenüber der Strahlrichtung, die in einer ersten Ebene (F) unterschiedlich zu einer zweiten Ebene (S) ist, wobei die erste Ebene durch die Fast-Axis-Richtung des Lichtemitters und die Strahlrichtung aufgespannt wird und die zweite Ebene durch die Slow-Axis Richtung des Lichtemitters und die Strahlrichtung, sodass die Ebenen orthogonal zueinander stehen, umfassend wenigstens eine erste Kollimationslinse (10) zur Kollimation des Lichtstrahlungsfeldes (L) in der ersten Ebene (F), nämlich zur Fast-Axis-Kollimation, und mindestens eine zweite Kollimationslinse (20) zur Kollimation des Lichtstrahlungsfeld(L) in der zweiten Ebene (S), nämlich zur Slow-Axis-Kollimation,
wobei

die Vorrichtung ein zusätzliches optisches Element (30) aufweist, welches derart konfiguriert ist, dass Anteile des Lichtstrahlungsfeldes (L), die mit der ersten und der zweiten Kollimationslinse noch nicht parallel ausgerichtet worden sind, parallel zur Strahlrichtung ausgerichtet werden, nämlich das Lichtstrahlungsfeld (L) in zumindest einer zur ersten Ebene (F) und zur zweiten Ebene (S) unterschiedlichen Ebene, die ebenfalls entlang der Strahlrichtung verläuft, kollimiert wird,
wobei die erste Kollimationslinse und die zweite Kollimationslinse sowie das zusätzliche optische Element einstückig ausgebildet sind, wobei das zusätzliche optische Element (30) durch einen Bereich auf der zweiten Kollimationslinse (10, 20) und als integraler Bestandteil der zweiten Kollimationslinse (20) ausgebildet ist,
**dadurch gekennzeichnet, dass**
der Bereich in Strahlungsrichtung (R) der zweiten Kollimationslinse (20) in Strahlungsrichtung (R) austrittsseitig angeordnet ist
und
eine Fläche zur Kollimation des Lichtstrahlungsfeldes in der zweiten Ebene (S) auf der zweiten Kollimationslinse (20) in Strahlungsrichtung (R) austrittsseitig angeordnet ist,
und die Kollimationslinse, die das zusätzliche optische Element umfasst, eine Oberflächentopographie mit der Form eines zweidimensionalen Polynoms gerader Ordnung aufweist, wobei das Polynom die Form
$h_{(x,y)} = a_{20} x^2 + a_{40} x^4 + a_{22} x^2 y^2 + a_{60} x^6 + a_{42} x^4 y^2 + a_{24} x^2 y^4$ aufweist, wobei h die Höhe der Oberfläche in Strahlrichtung angibt und wobei x und y die orthogonalen Koordinatenachsen in der Ebene senkrecht zur Strahlungsrichtung (R) sind und die Parameter a ungleich null sind.

2. Vorrichtung (100) nach Anspruch 1, **dadurch gekennzeichnet, dass**

- das Polynom Koeffizienten mit einem Wert kleiner null für die $x^{2n}$-Terme aufweist, insbesondere sind mindestens die Koeffizienten des $x^2$- und des $x^4$- Terms kleiner null,
und/oder
- das Polynom weist Koeffizienten mit einem Wert grösser null für die $x^{2n} y^{2m}$ Terme auf, insbesondere ist mindestens der Koeffizient des $x^2 y^2$- Terms grösser null.

3. Hochleistungsdiodenlaser umfassend zumindest einen Emitter, bevorzugt mehrere Emitter, und wenigstens eine Vorrichtung nach einem der Ansprüche 1 bis 2.

4. Hochleistungsdiodenlaser nach Anspruch 3 umfassend ein Array aus mehreren Emittern, die in einer Ursprungsebene entlang der ersten Ebene (F) und/oder entlang der zweiten Ebene (S) nebeneinander angeordnet sind, wobei jedem Emitter ein zusätzliches optisches Element (30) zugeordnet ist.

5. Modul umfassend eine Vorrichtung (100) nach einem der Ansprüche 1 bis 3 und eine Fokussieroptik oder umfassend einen Hochleistungsdiodenlaser nach Anspruch 3 oder 4 und eine Fokussieroptik.

6. Kollimationslinsenarray, für einen Hochleistungsdiodenlaser nach Anspruch 3 oder 4 oder ein Modul nach Anspruch 5, umfassend zwei oder mehrere erste Kollimationslinsen (10) zur Kollimation eines Lichtstrahlungsfeldes (L) in der ersten Ebene (F) und zwei oder mehrere zweite Kollimationslinsen (20) zur Kollimation des Lichtstrahlungsfeldes (L) in der zweiten Ebene (S), wobei die erste Kollimationslinse (10) und die zweite Kollimationslinse (20) und das zusätzliche optische Element (30) jeweils einstückig ausgebildet sind, so dass das Kollimationslinsenarray je zweiter Kollimationslinse (10,20) das zusätzliche optische Element (30) aufweist.

7. Verfahren zum Kollimieren eines Lichtstrahlungsfeldes (L) mit einer Strahlcharakteristik, die in einer ersten Ebene (F) unterschiedlich zu einer zweiten Ebene (S) ist, mit einer Vorrichtung (100) nach einem der Ansprüche 1 bis 2, umfassend die Schritte

- erste Kollimation der Anteile des Lichtstrahlungsfeldes (L) der ersten Ebene (F), nämlich Fast- Axis-Kollimation mit einer ersten Kollimationslinse,

- zweite Kollimation der Anteile des Lichtstrahlungsfeldes (L) der zweiten Ebene (S), nämlich Slow-Axis-Kollimation mit einer zweiten Kollimationslinse,

- Kollimation von Anteilen des Lichtstrahlungsfeldes, welche durch die erste und zweite Kollimation noch nicht parallel zur Strahlrichtung ausgerichtet wurden, die zur ersten Ebene (F) und zur zweiten Ebene (S) unterschiedliche Ebenen aufweisen.

**Claims**

1. Device (100) for collimating a light radiation field (L) emanating from at least one light emitter and having a beam characteristic with respect to the beam angle relative to the beam direction which is different in a first plane (F) from a second plane (S), the first plane being spanned by the fast-axis direction of the light emitter and the beam direction and the second plane being spanned by the slow-axis direction of the light emitter and the beam direction, so that the planes are orthogonal to one another, comprising at least one first collimating lens (10) for collimating the light radiation field (L) in the first plane (F), namely for fast-axis collimation, and at least one second collimating lens (20) for collimating the light radiation field (L) in the second plane (S), namely for slow-axis collimation,
wherein

the device has an additional optical element (30) which is configured such that portions of the light radiation field (L) which have not yet been aligned parallel with the first and the second collimating lens are aligned parallel to the beam direction, namely the light radiation field (L) is collimated in at least one plane which is different from the first plane (F) and from the second plane (S) and which also extends along the beam direction, wherein the first collimating lens and the second collimating lens as well as the additional optical element are formed in one piece, wherein the additional optical element (30) is formed by a region on the second collimating lens (10, 20) and as an integral part of the second collimating lens (20),
**characterized in that** the region is arranged in the direction of radiation (R) of the second collimating lens (20) on the exit side in the direction of radiation (R) and
a surface for collimating the light radiation field in the second plane (S) is arranged on the second collimating lens (20) on the exit side in the radiation direction (R),
and the collimating lens, which comprises the additional optical element, has a surface topography with the form of a two-dimensional polynomial of even order, the polynomial having the form

$$h_{(x,y)} = a_{20}\, x^2 + a_{40}\, x^4 + a_{22}\, x^2 y^2 + a_{60}\, x^6 + a_{42}\, x^4 y^2 + a_{24}\, x^2 y^4,$$

where h indicates the height of the surface in the direction of radiation and where x and y are the orthogonal coordinate axes in the plane perpendicular to the direction of radiation (R) and the parameters a are not equal to zero.

2. Device (100) according to claim 1, **characterized in that**

- the polynomial has coefficients with a value less than zero for the $x^{2n}$-terms, in particular at least the coefficients of the $x^2$- and $x^4$-term are less than zero,
and/or
- the polynomial has coefficients with a value greater than zero for the $x^{2n} y^{2m}$ terms, in particular at least the coefficient of the $x^2 y^2$-term is greater than zero.

3. High-power diode laser comprising at least one emitter, preferably several emitters, and at least one device according to one of claims 1 to 2.

4. High-power diode laser according to claim 3 comprising an array of several emitters which are arranged next to each other in an original plane along the first plane (F) and/or along the second plane (S), wherein each emitter is assigned an additional optical element (30).

5. Module comprising a device (100) according to one of claims 1 to 3 and a focusing optics or comprising a high-power diode laser according to claim 3 or 4 and a focusing optics.

**6.** A collimating lens array, for a high power diode laser according to claim 3 or 4 or a module according to claim 5, comprising two or more first collimating lenses (10) for collimating a light radiation field (L) in the first plane (F) and two or more second collimating lenses (20) for collimating the light radiation field (L) in the second plane (S), wherein the first collimating lens (10) and the second collimating lens (20) and the additional optical element (30) are each formed in one piece, so that the collimating lens array has the additional optical element (30) for each second collimating lens (10, 20) .

**7.** Method for collimating a light radiation field (L) with a beam characteristic which is different in a first plane (F) from a second plane (S), with a device (100) according to one of claims 1 to 2, comprising the steps of

- first collimation of the portions of the light radiation field (L) of the first plane (F), namely fast-axis collimation with a first collimating lens,
- second collimation of the portions of the light radiation field (L) of the second plane (S), namely slow-axis collimation with a second collimating lens,
- collimation of parts of the light radiation field which have not yet been aligned parallel to the beam direction by the first and second collimation, which have different planes to the first plane (F) and to the second plane (S).

**Revendications**

**1.** Dispositif (100) de collimation d'un champ de rayonnement lumineux (L) émanant d'au moins un émetteur de lumière avec une caractéristique de faisceau en ce qui concerne l'angle de rayonnement par rapport à la direction du faisceau, qui est différente dans un premier plan (F) par rapport à un deuxième plan (S), le premier plan étant défini par la direction de l'axe fast de l'émetteur de lumière et la direction du faisceau et le deuxième plan par la direction de l'axe slow de l'émetteur de lumière et la direction du faisceau, de sorte que les plans sont orthogonaux l'un à l'autre, comprenant au moins une première lentille de collimation (10) pour la collimation du champ de rayonnement lumineux (L) dans le premier plan (F), à savoir pour la collimation d'axe fast, et au moins une deuxième lentille de collimation (20) pour la collimation du champ de rayonnement lumineux (L) dans le deuxième plan (S), à savoir pour la collimation d'axe slow,
dans lequel

le dispositif présente un élément optique supplémentaire (30) qui est configuré de telle sorte que des parties du champ de rayonnement lumineux (L) qui n'ont pas encore été alignées parallèlement avec la première et la deuxième lentille de collimation sont alignées parallèlement à la direction du faisceau, à savoir que le champ de rayonnement lumineux (L) est collimaté dans au moins un plan différent du premier plan (F) et du deuxième plan (S), qui s'étend également le long de la direction du faisceau,
la première lentille de collimation et la deuxième lentille de collimation ainsi que l'élément optique supplémentaire sont formés d'un seul tenant, l'élément optique supplémentaire (30) étant formé par une zone sur la deuxième lentille de collimation (10, 20) et faisant partie intégrante de la deuxième lentille de collimation (20), **caractérisé en ce que**
la zone est disposée dans la direction de rayonnement (R) de la deuxième lentille de collimation (20) du côté de la sortie dans la direction de rayonnement (R)
et
une surface pour la collimation du champ de rayonnement lumineux dans le deuxième plan (S) est disposée sur la deuxième lentille de collimation (20) du côté de la sortie dans la direction de rayonnement (R),
et la lentille de collimation comprenant l'élément optique supplémentaire a une topographie de surface ayant la forme d'un polynôme bidimensionnel d'ordre pair, le polynôme ayant la forme

$$h_{(x,y)} = a_{20}\, x^2 + a_{40}\, x^4 + a_{22}\, x^2 y^2 +\ a_{60}\, x^6 + a_{42}\, x^4 y^2 + a_{24}\, x^2 y^4,$$

dans laquelle h est la hauteur de la surface dans la direction du faisceau et dans laquelle x et y sont les axes de coordonnées orthogonales dans le plan perpendiculaire à la direction du faisceau (R) et les paramètres a ne sont pas zéro.

**2.** Dispositif (100) selon la revendication 1, **caractérisé en ce que**

- le polynôme présente des coefficients ayant une valeur inférieure à zéro pour les termes $x^{2n}$-, notamment au

moins les coefficients des termes $x^2$ et $x^4$ sont inférieurs à zéro,
et/ou
- le polynôme présente des coefficients d'une valeur supérieure pour les termes $x^{2n}y^{2m}$, en particulier au moins le coefficient du terme $x^2y^2$ est supérieur à zéro.

3. Laser à diode de forte puissance comprenant au moins un émetteur, de préférence plusieurs émetteurs, et au moins un dispositif selon l'une des revendications 1 à 2.

4. Laser à diode à forte puissance selon la revendication 3, comprenant un réseau de plusieurs émetteurs qui sont disposés côte à côte dans un plan d'origine le long du premier plan (F) et/ou le long du deuxième plan (S), un élément optique supplémentaire (30) étant associé à chaque émetteur.

5. Module comprenant un dispositif (100) selon l'une des revendications 1 à 3 et une optique de focalisation ou comprenant un laser à diode de forte puissance selon la revendication 3 ou 4 et une optique de focalisation.

6. Réseau de lentilles de collimation, pour un laser à diode de forte puissance selon la revendication 3 ou 4 ou un module selon la revendication 5, comprenant deux ou plusieurs premières lentilles de collimation (10) pour collimater un champ de rayonnement lumineux (L) dans le premier plan (F) et deux ou plusieurs secondes lentilles de collimation (20) pour collimater le champ de rayonnement lumineux (L) dans le second plan (S), les premières lentilles de collimation (10) et les deuxièmes lentilles de collimation (20) et l'élément optique supplémentaire (30) étant respectivement formés d'une seule pièce, de sorte que le réseau de lentilles de collimation comporte l'élément optique supplémentaire (30) pour chaque deuxième lentille de collimation (10, 20).

7. Procédé de collimation d'un champ de rayonnement lumineux (L) avec une caractéristique de faisceau qui est différente dans un premier plan (F) par rapport à un deuxième plan (S), avec un dispositif (100) selon l'une des revendications 1 à 2, comprenant les étapes suivantes

   - première collimation des parties du champ de rayonnement lumineux (L) du premier plan (F), à savoir collimation par axe fast avec une première lentille de collimation,
   - deuxième collimation des parties du champ de rayonnement lumineux (L) du deuxième plan (S), à savoir collimation à axe lent avec une deuxième lentille de collimation,
   - collimation de parties du champ de rayonnement lumineux qui n'ont pas encore été alignées parallèlement à la direction du faisceau par la première et la deuxième collimation, qui présentent des plans différents par rapport au premier plan (F) et au deuxième plan (S).

100

R

S

L  10    L1    20    L2

F

FIG 1

E20

21

A20

20

FIG 1a

Detector Image: Radiant Intensity

28.07.2016
Detector 4, NSCG Surface 1:
Size X: -0.150 to 0.150, Y: -0.200 to 0.200 deg, Pixels 100 W X 100 H, Total Hits = 990310
Peak Intensity : 2.2891E+005 Watts/Steradian
Total Power    : 9.9031E-001 Watts

fac_sac.zmx
Configuration 1 of 1

FIG 2

FIG 3

E20

30

21'

A20

20'

FIG 3a

341253

307128

273003

238877

204752

170627

136501

102376

68251

34125

0

Detector Image: Radiant Intensity

28.07.2016
Detector 4, NSCG Surface 1:
Size X: -0.150 to 0.150, Y: -0.200 to 0.200 deg, Pixels 100 W X 100 H, Total Hits = 1000000
Peak Intensity : 3.4125E+005 Watts/Steradian
Total Power : 1.0000E+000 Watts

fac_sac_free.zmx
Configuration 1 of 1

FIG 4

FIG 5a

FIG 5b

FIG 5c

FIG 6a

FIG 6b

FIG 6c

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 20160274368 A1
- US 6195208 B1

**In der Beschreibung aufgeführte Nicht-Patentliteratur**

- *Jpn. J Appl. Phys.,* 1994, vol. 33, 1363-1364
- **DRUCKSCHRIFT MARTIN HUNTEN et al.** Precision glass molding: an integrative approach for the production of high precision micro-optics. *Proceedings of SPIE,* 11. Februar 2010, vol. 7591, 75910X
- **DRUCKSCHRIFT SERKAN M et al.** Optical beam-shaping design based on aspherical lenses for circularization, collimation, and expansion of elliptical laser beams. *APPLIED OPTICS,* 10. Januar 2008, vol. 47, 230-241